# EUROPEAN PATENT APPLICATION

(11) **EP 2 916 121 A1**
(43) Date of publication of application: **09.09.2015**
(21) Application number: 15155260.1
(22) Date of filing: 16.02.2015
(51) Int. Cl.: G01N 1/32

(54) **APPARATUS AND METHOD FOR SAMPLE PREPARATION**

(30) Priority: 05.03.2014 JP 2014042516
(71) Applicant: JEOL Ltd., Akishima, Tokyo 196 (JP)
(72) Inventor: Negishi, Tsutomu, Akishima, Tokyo 196-8558 (JP)
(74) Representative: Boult Wade Tennant

(57) **Abstract**

A sample preparation apparatus capable of preparing a cross section having a thin amorphous region is offered. The sample preparation apparatus (100) is used to prepare a cross section of a sample (S) by irradiating it with an ion beam. The apparatus (100) includes an ion beam generator (10) producing the ion beam, a shield plate (40) disposed to cover a part of the sample (S) and operative to shield the sample (S) from the ion beam, and a controller (82) for controlling the ion beam generator (10). The controller (82) performs first and second operations. In the first operation, the controller controls the ion beam generator (10) such that the ion beam is accelerated by a first accelerating voltage and hits the sample (S) while the sample (S) and the shield plate (40) are located in a given positional relationship. In the second operation, the controller controls the ion beam generator (10) such that the ion beam is accelerated by a second accelerating voltage lower than the first accelerating voltage and hits the sample (S) while the given positional relationship is maintained.

## Description

### BACKGROUND OF THE INVENTION

### 1. Field of the Invention

The present invention relates to an apparatus and method for sample preparation.

### 2. Description of the Related Art

Mechanical polishing of a sample is known as a method of preparing a sample to be observed or analyzed by an electron microscope. In mechanical polishing, however, a force is applied to the surface to be processed and so softer portions may be erased earlier, resulting in unevenness or softer portions may be crushed. Furthermore, in some cases, a harder material is buried in a softer portion. Therefore, when a method of mechanical polishing is employed, it has been difficult to smoothly polish a joint or interface between materials having different degrees of hardness. In this way, with a method of mechanical polishing, it has been difficult to prepare a sample section without varying the morphology or composition of the sample.

Faced with this problem, patent document 1 discloses a sample preparation apparatus for processing samples using a Cross Section Polisher (CP) permitting preparation of cross sections that are relatively unaffected by a polishing work. In the sample preparation apparatus disclosed in this patent document 1, a shield plate for blocking an ion beam is placed on a sample to control the region of the sample irradiated with the ion beam. The ion beam is made to hit the region of the sample that is not shielded by the shield plate, thus processing the sample.

### Citation List

### Patent Documents

Patent document 1: JP-A-2011-192521

However, it is known that even if a sample preparation apparatus such as the sample preparation apparatus of patent document 1 that uses an ion beam and an ion beam shielding material is employed, when a crystalline sample section is prepared, the crystallinity of the topmost surface is disturbed. The depth of the amorphized sample portion having the disturbed crystallinity differs according to the accelerating voltage of the ion beam. The depth tends to increase with the accelerating voltage.

### SUMMARY OF THE INVENTION

In view of the foregoing problem, the present invention has been made. It would be desirable to provide a sample preparation apparatus capable of preparing a sample cross section having a thin amorphous region. It would be further desirable to provide a sample preparation method capable of preparing a sample cross section having a thin amorphous region.

According to the present invention, there is provided:
(1) A sample preparation apparatus associated with the present invention prepares a cross section of a sample by irradiating the sample with an ion beam. The apparatus includes: an ion beam generator producing the ion beam; a shield plate disposed to cover a part of the sample and operative to shield the sample from the ion beam; and a controller for controlling the ion beam generator. The controller performs a first operation, wherein the controller controls the ion beam generator such that the ion beam is accelerated by a first accelerating voltage and hits the sample while the sample and the shield plate are located in a given positional relationship, and a second operation, wherein the controller controls the ion beam generator such that the ion beam is accelerated by a second accelerating voltage lower than the first accelerating voltage and hits the sample while the given positional relationship is maintained.

In this sample preparation apparatus, a cross section having a thin amorphous region can be prepared efficiently.
(2) In one feature of this sample preparation apparatus, there is further provided a storage device in which first processing conditions and second processing conditions for the first operation and the second operation, respectively, are stored. The first processing conditions include information about a duration of the ion beam irradiation and information about the first accelerating voltage. The second processing conditions include information about a duration of the ion beam irradiation and information about the second accelerating voltage. The controller may perform the first operation on the basis of the first processing conditions stored in the storage device and perform the second operation on the basis of the second processing conditions stored in the storage device.

In this sample preparation apparatus, the second operation can be carried out automatically, for example, after the first operation.
(3) A sample preparation method associated with the present invention is used to prepare a section of a sample by irradiating the sample with an ion beam. The method starts with a first operation, wherein the ion beam is accelerated by a first accelerating voltage and hits the sample while the sample and a shield plate are located in a given positional relationship. A second operation is then performed in which the ion beam is accelerated by a second accelerating voltage lower than the first accelerating voltage and hits the sample while the given positional relationship is maintained.

In this sample preparation method, a cross section having a thin amorphous region can be prepared efficiently.
(4) In one feature of this sample preparation method, during the first operation, the irradiation by the ion beam with the first accelerating voltage may be terminated before the cross section of the sample becomes parallel to an optical axis of the ion beam.

In this sample preparation method, a cross section having a thin amorphous region can be prepared efficiently.
(5) In another feature of this sample preparation method, the shield plate has a side surface tilted relative to the optical axis of the ion beam. During the first operation, the irradiation by the ion beam with the first accelerating voltage may be terminated after the tilt of the cross section of the sample relative to the optical axis of the ion beam has become less steep than the tilt of the side surface of the shield plate relative to the optical axis of the ion beam.

In this sample preparation method, a cross section having a thin amorphous region can be prepared efficiently.

### BRIEF DESCRIPTION OF THE DRAWINGS

FIGS. 1 and 2 are schematic views, partly in block form, of a sample preparation apparatus associated with a first embodiment of the present invention, showing different states.
FIG. 3 is a schematic view of the sample stage of the sample preparation apparatus shown in FIGS. 1 and 2.
FIG. 4 is a schematic cross section of the sample and the shield plate shown in FIGS. 1-3, the cross section being taken during ion beam irradiation.
FIG. 5 is a flowchart illustrating one example of sample preparation method associated with the first embodiment.
FIG. 6 shows one example of control GUI screen of the sample preparation apparatus shown in FIGS. 1 and 2.
FIGS. 7A-7E are schematic cross-sectional views of a sample cross section, illustrating the manner in which the cross section varies during a coarse processing operation.
FIG. 8 shows one example of control GUI screen of a sample preparation apparatus associated with a second embodiment of the present invention.
FIG. 9 shows an EBSD pattern of a cross section of a silicon substrate prepared using an Ar ion beam with an accelerating voltage of 8 kV.
FIG. 10 shows an EBSD pattern of a cross section of a silicon substrate prepared by processing the substrate by an Ar ion beam with an accelerating voltage of 3 kV for 3 minutes after the substrate was processed by an Ar ion beam with an accelerating voltage of 8 kV.

### DESCRIPTION OF THE PREFERRED EMBODIMENTS

The preferred embodiments of the present invention are hereinafter described in detail with reference to the drawings. It is to be understood that the embodiments provided below do not unduly restrict the scope and content of the present invention delineated by the appended claims and that not all the configurations described below are essential constituent components of the invention.

### 1. First Embodiment

### 1.1. Sample Preparation Apparatus

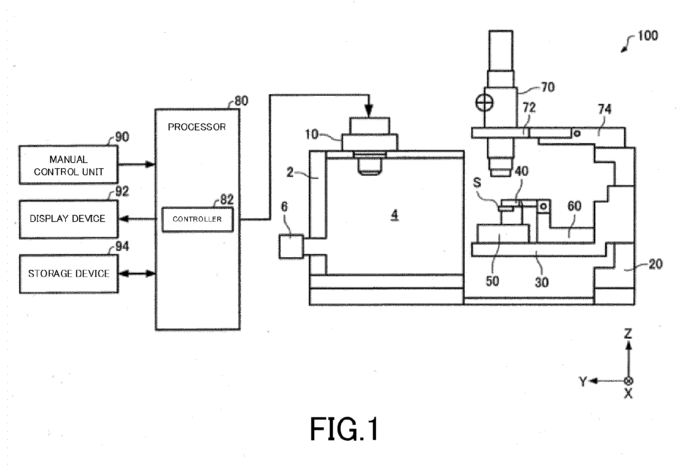

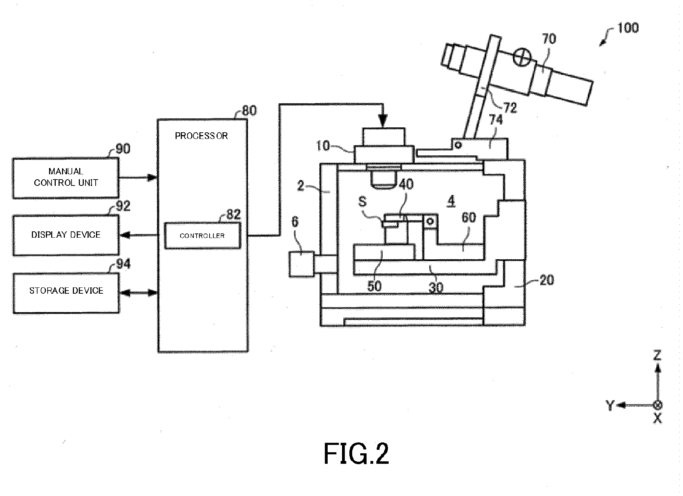

A sample preparation apparatus associated with a first embodiment of the present invention is first described by referring to FIGS. 1 and 2, which schematically show the sample preparation apparatus, generally indicated by reference numeral 100. In FIGS. 1 and 2, for the sake of convenience, X-, Y-, and Z-axes are shown as three axes perpendicular to each other.

As shown in FIG. 1, the sample preparation apparatus 100 includes an ion beam generator 10, a sample stage extracting mechanism 20, a sample stage 30, a shield plate 40, a sample position adjusting mechanism 50, a shield plate position adjusting mechanism 60, an optical microscope 70, a processor 80, a manual control unit 90, a display device 92, and a storage device 94. FIG. 1 shows a state in which the sample stage extracting mechanism 20 is open. FIG. 2 shows a state in which the extracting mechanism 20 is closed.

The ion beam generator 10 produces an ion beam, and is mounted over a vacuum chamber 2. For example, the ion beam generator 10 is an ion gun. The ion beam generator 10 emits the ion beam, which can be an Ar ion beam, by accelerating it by a given accelerating voltage. The ion beam emitted from the ion beam generator 10 travels along the Z-axis, and has an optical axis parallel, for example, to the Z-axis.

The sample stage extracting mechanism 20 is mounted to the vacuum chamber 2 such that the mechanism 20 can be opened and closed. The sample stage 30 is mounted to the sample stage extracting mechanism 20, and can be pulled out of a processing chamber 4 as shown in FIG. 1 by opening the sample stage extracting mechanism 20. The sample stage 30 can be inserted into the processing chamber 4 as shown in FIG. 2 by closing the extracting mechanism 20. When the extracting mechanism 20 has been closed, the processing chamber 4 is evacuated by vacuum pumping equipment 6.

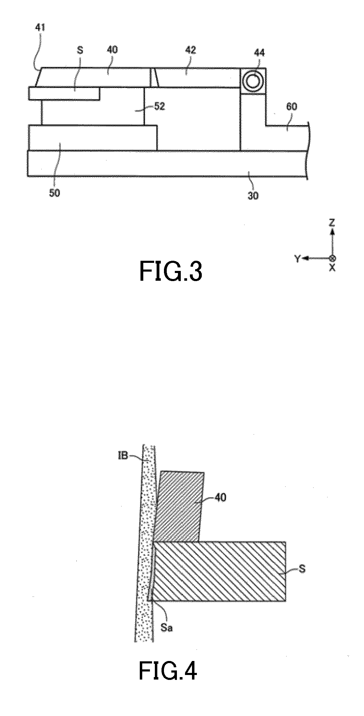

FIG. 3 schematically shows the sample stage 30 of the sample preparation apparatus 100. The sample position adjusting mechanism 50 is disposed on the sample stage 30. A sample holder 52 on which a sample S is placed is mounted on the sample position adjusting mechanism 50. This adjusting mechanism 50 is configured so as to be able to move the sample holder 52 and the sample S on the holder 52 in the directions of the X- and Y-axes.

The shield plate 40 is disposed to cover a part of the sample S and can shield the sample S from the ion beam. That is, the shield plate 40 is a member for shielding an unprocessed region of the sample S from the ion beam. The shield plate 40 is held by a shield plate holding mechanism 42. The shield plate 40 has a side surface 41 that is tilted relative to the optical axis (Z-axis in the illustrated example) of the ion beam released from the ion beam generator 10.

The shield plate holding mechanism 42 is tiltably mounted to a shield plate tilting mechanism 44. The holding mechanism 42 can retract the shield plate 40 from above the sample S by rotating about an axis parallel to the X-axis. The shield plate position adjusting mechanism 60 is disposed on the sample stage 30 and configured to be able to move the shield plate 40 in the direction of the Y-axis.

In the sample preparation apparatus 100, the positional relationship between the sample S and the shield plate 40 is varied by the sample position adjusting mechanism 50 and shield plate position adjusting mechanism 60. That is, the adjusting mechanisms 50 and 60 together operate as a positional relationship adjusting portion for varying the positional relationship between the sample S and the shield plate 40.

As shown in FIGS. 1 and 2, an optical microscope position adjusting mechanism 72 holds the optical microscope 70. The adjusting mechanism 72 is tiltably mounted to an optical microscope tilting mechanism 74. When the sample stage extracting mechanism 20 is closed as shown in FIG. 2, the optical microscope 70 and the optical microscope position adjusting mechanism 72 are located outside the vacuum chamber 2.

The manual control unit 90 permits a user to enter control information. The manual control unit 90 outputs the entered control information to a controller 82. The user can adjust the position of the sample S or the position of the shield plate 40 by manipulating the manual control unit 90 so as to operate either the sample position adjusting mechanism 50 or the shield plate position adjusting mechanism 60. The function of the manual control unit 90 can be implemented by a keyboard, a mouse, buttons, a touch panel display, or other hardware device.

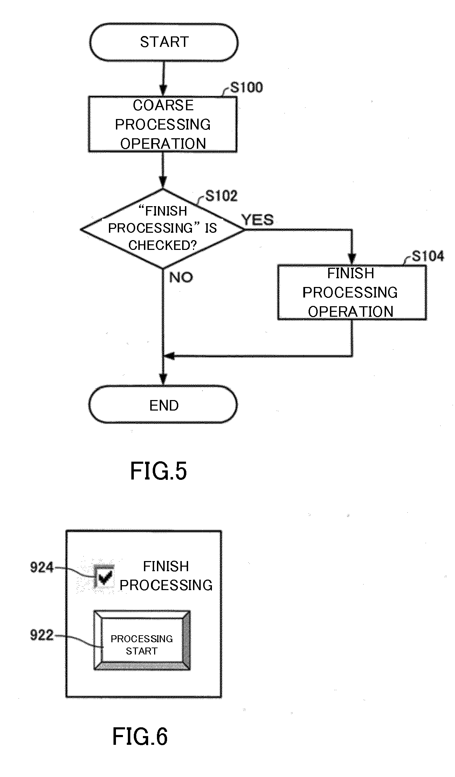

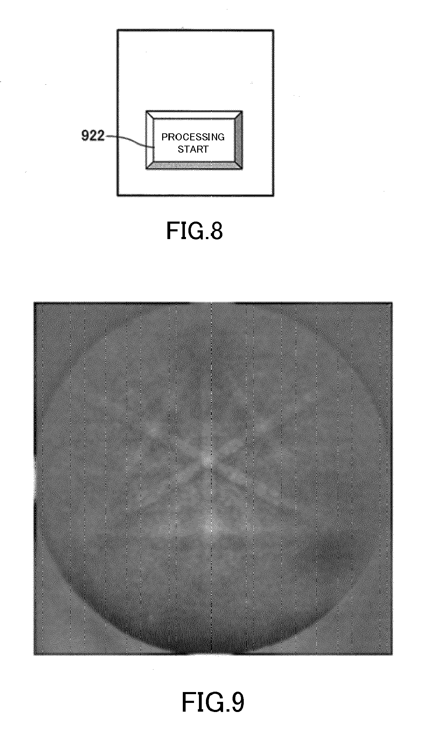

The display device 92 displays the image created by the processor 80. The function of the display device 92 can be implemented by an LCD, a CRT, or the like. A control GUI screen described later in connection with FIGS. 6 and 8 is displayed on the display device 92.

Computer programs and various types of data for causing a computer to act as various parts of the processor 80 are stored in the storage device 94. Also, the storage device 94 operates as a working area for the processor 80. The function of the storage device 94 can be implemented by a hard disk, a RAM, or the like. Processing conditions such as accelerating voltages, flow rates of discharge gas, processing times, and so on are stored in the storage device 94. More specifically, coarse processing conditions (also referred to as first processing conditions) including information related to a coarse processing operation (also referred to as a first operation) and about durations of ion beam irradation and ion beam accelerating voltages (also referred to as first accelerating voltages) and finish processing conditions (also referred to as second processing conditions) including information related to a finish processing operation (also referred to as a second operation) and about durations of ion beam irradiation and ion beam accelerating voltages (also referred to as second accelerating voltages) as described later are stored in the storage device 94.

The coarse processing conditions and the finish processing conditions may include information about flow rates of discharge gas, swinging motion of the sample stage, and conditions of intermittent processing (ON time and OFF time of the ion beam), as well as irradiation time and accelerating voltage.

The processor 80 performs an operation for controlling the accelerating voltage of the ion beam released from the ion beam generator 10, an operation for controlling the sample position adjusting mechanism 50 and the shield plate position adjusting mechanism 60, and so on. The functions of the processor 80 can be implemented by hardware such as various processing units (e.g., a CPU, a DSP, or the like), an ASIC (e.g., a gate array) or by software. The processor 80 includes the controller 82.

The controller 82 generates control signals on the basis of the control information from the manual control unit 90 and outputs the generated control signals to the ion beam generator 10, sample position adjusting mechanism 50, and shield plate position adjusting mechanism 60 to control the operation of these ion beam generator 10 and position adjusting mechanisms 50, 60.

The controller 82 performs the coarse processing operation (first operation) and the finish processing operation (second operation). In the coarse processing operation, the ion beam generator 10 is controlled such that the ion beam is accelerated by the first accelerating voltage and directed at the sample S while the sample S and the shield plate 40 are located in a given positional relationship. In the finish processing operation, the ion beam generator 10 is controlled such that the ion beam is accelerated by the second accelerating voltage lower than the first accelerating voltage and directed at the sample S while the given positional relationship is maintained. That is, during the finish processing operation, the controller 82 reduces the ion beam accelerating voltage and processes the cross section of the sample S without varying the positional relationship established between the sample S and the shield plate 40 in the coarse processing operation.

The first accelerating voltage is approximately 8 kV, for example. The second accelerating voltage is approximately 3 kV, for example. The second accelerating voltage is 80% or less of the first accelerating voltage. The first and second accelerating voltages are appropriately set depending on the material of the sample S and on the required thickness of the amorphous region.

The controller 82 performs the coarse processing operation (first operation) on the basis of the coarse processing conditions stored in the storage device 94 and performs the finish processing operation (second operation) on the basis of the finish processing conditions stored in the storage device 94. By previously storing these processing conditions in the storage device 94, the controller 82 can automatically perform the finish processing operation after the coarse processing operation.

The sample preparation apparatus 100 has the following features. In the sample preparation apparatus 100, the controller 82 performs the coarse processing operation, wherein the ion beam generator 10 is controlled such that the ion beam is accelerated by the first accelerating voltage and hits the sample S while the sample S and the shield plate 40 are located in a given positional relationship, and the finish processing operation, wherein the ion beam generator 10 is controlled such that the ion beam is accelerated by the second accelerating voltage lower than the first accelerating voltage and hits the sample S while the given positional relationship is maintained. Consequently, the sample preparation apparatus 100 can prepare a cross section having a thin amorphous region efficiently.

The amorphous region is described now. FIG. 4 is a schematic cross-sectional view of the sample S and the shield plate 40, taken during irradiation by the ion beam, IB. When the crystalline sample S is processed and a cross section is prepared, ions colliding with the sample surface produces an interaction with the sample surface, thus disturbing the crystallinity of the sample S. Consequently, an amorphous region Sa is formed. As the energy of the ion beam IB is increased, the interaction of the ions produced when they collide against the sample surface spreads deeper into the sample S, disturbing crystals present more deeply within the sample S. This increases the thickness of the amorphous region Sa. By lowering the accelerating voltage, the range of interaction can be made shallower, and the amorphous region Sa can be made thinner.

The sample preparation apparatus 100 can prepare a cross section having a thin amorphous region in a shorter time than in a case where the sample is processed using only a low accelerating voltage and also than in a case where a sample is processed by a high accelerating voltage, then the positional relation between the sample and the shield plate is varied, and the sample is processed by a low accelerating voltage. Furthermore, the sample preparation apparatus 100 can prepare a cross section having a thinner amorphous region than where the sample is processed with only a high accelerating voltage. In this way, the sample preparation apparatus 100 can prepare a cross section having a thin amorphous region efficiently.

In the sample preparation apparatus 100, the storage device 94 stores coarse processing conditions including information about an ion beam irradiation time and the first accelerating voltage used in the coarse processing operation and finish processing conditions including information about ion beam irradiation times and the second accelerating voltage used in the finish processing operation. The controller 82 performs the coarse processing operation on the basis of the coarse processing conditions stored in the storage device 94 and performs the finish processing operation on the basis of the finish processing conditions stored in the storage device 94. Therefore, the sample preparation apparatus 100 can automatically perform the finish processing operation, for example, after the coarse processing operation.

### 1. 2. Sample Preparation Method

A sample preparation method associated with the first embodiment is next described by referring to FIGS. 1-5. This method is implemented using the sample preparation apparatus 100. FIG. 5 is a flowchart illustrating one example of the sample preparation method associated with the first embodiment.

First, the positional relationship between the sample S and the shield plate 40 is adjusted, and the position where a cross section of the sample S is prepared is set. In particular, the sample stage extracting mechanism 20 is first closed and the processing chamber 4 is evacuated. Under this condition shown in FIG. 2, the ion beam is directed at an arbitrary position on the sample S for a given time to form an ion beam trace. Then, the sample stage extracting mechanism 20 is opened to expose the processing chamber 4 to the atmosphere. Under this condition shown in FIG. 1, the optical microscope position adjusting mechanism 72 is manipulated to adjust the position of the optical microscope 70 such that the ion beam trace is brought to the center of the field of view of the optical microscope 70. Consequently, the optical axis of the optical microscope 70 can be brought into coincidence with the optical axis of the ion beam.

Then, the user manipulates the manual control unit 90 while observing the shield plate 40 with the optical microscope 70 to operate the shield plate position adjusting mechanism 60 via the controller 82 such that the position of the side surface 41 of the shield plate 40 is adjusted so as to be brought onto the optical axis of the optical microscope 70. The user then manipulates the manual control unit 90 while observing the sample S with the optical microscope 70 to operate the sample position adjusting mechanism 50 via the controller 82 such that a position where a cross section of the sample S is prepared is brought just below one end of the shield plate 40. Because of the processing steps described so far, the position where a cross section of the sample S is prepared can be set.

If the position where a cross section is prepared is set as described above, the sample stage extracting mechanism 20 is closed again and the processing chamber 4 is evacuated. If the user manipulates the manual control unit 90 to start processing of the sample, the manual control unit 90 outputs a start signal to the controller 82. FIG. 6 shows one example of control GUI (graphical user interface) screen of the sample preparation apparatus 100. The user depresses a processing start button 922 in the control GUI screen displayed on the display device 92 and shown in FIG. 6. The manual control unit 90 outputs the start signal to the controller 82.

In response to the start signal, the controller 82 performs the coarse processing operation (step S100). In particular, the controller 82 controls the ion beam generator 10 to accelerate the ion beam by the first accelerating voltage and to direct the beam at the sample S while the sample S and the shield plate 40 are placed in position by the above-described positioning step (i.e., a given positional relationship is established between them). The controller 82 performs the coarse processing operation on the basis of the coarse processing conditions stored in the storage device 94.

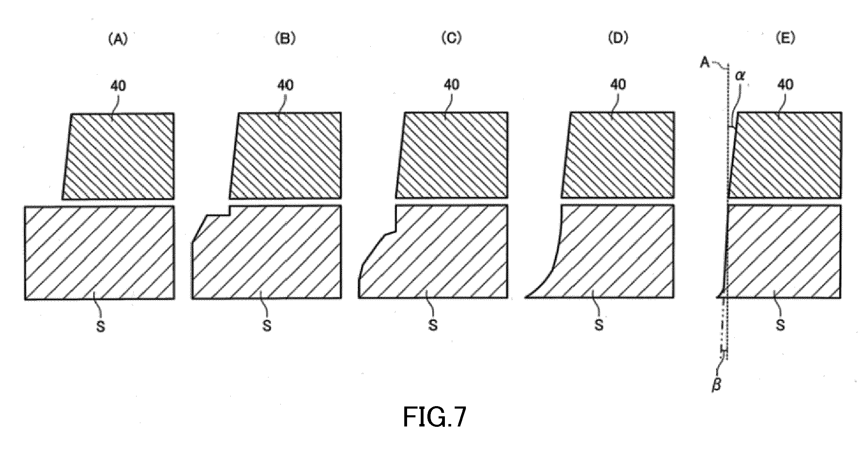

FIGS. 7A-7E are schematic cross sections showing the manner in which a cross section of the sample S varies during the coarse processing operation. The cross section of the sample S is processed successively as shown in FIGS. 7A-7E. In the present embodiment, as shown in FIG. 7E, the coarse processing operation is terminated after the angle of tilt β of the cross section of the sample S relative to the optical axis A of the ion beam becomes smaller than the angle of tilt α of the side surface 41 of the shield plate 40 relative to the optical axis A of the ion beam and before the optical axis A of the ion beam and the cross section of the sample S become parallel to each other. For example, where the angle of tilt α of the side surface 41 of the shield plate 40 relative to the optical axis A of the ion beam is 1.5° (degrees), when the angle of tilt β of the cross section of the sample S relative to the optical axis A of the ion beam reaches 1.0° (degree), the coarse processing operation is terminated. For example, experiments or simulations are previously performed to find the processing conditions such as accelerating voltage and processing time. The processing conditions are stored in the storage device 94. Thus, the controller 82 can end the coarse processing operation under the above-described conditions.

After the end of the coarse processing operation, if a finish processing check column 924 in the control GUI screen shown in FIG. 6 is checked (i.e., the decision at step S102 is affirmative (YES)), the controller 82 performs a finish processing operation (step S104). In particular, the controller 82 controls the ion beam generator 10 such that the ion beam is accelerated by the second accelerating voltage lower than the first accelerating voltage and directed at the sample S when the positional relationship between the sample S and the shield plate 40 is the same as during the coarse processing operation. That is, after the coarse processing operation, the finish processing operation is carried out without operating the sample position adjusting mechanism 50 or the shield plate position adjusting mechanism 60. The controller 82 performs the finish processing operation on the basis of the finish processing conditions stored in the storage device 94. After the end of the finish processing operation, the controller 82 ends the present processing subroutine.

After the end of the coarse processing operation, if the finish processing check column 924 (FIG. 6) in the control GUI screen is not checked (i.e., the decision at step S102 is negative (NO)), the controller 82 ends the present processing subroutine.

The sample preparation method associated with the first embodiment has the following features. A sample preparation method associated with the first embodiment is used to prepare a cross section of the sample S by irradiating the sample S with an ion beam. The method involves performing a coarse processing operation, wherein the ion beam is accelerated by the first accelerating voltage and hits the sample S while the sample S and the shield plate 40 are located in a given positional relationship, and a finish processing operation, wherein the ion beam is accelerated by the second accelerating voltage lower than the first accelerating voltage and hits the sample S while the given positional relationship is maintained. Consequently, with the sample preparation method associated with the first embodiment, it is possible to prepare a cross section having a thin amorphous region efficiently.

In the sample preparation method associated with the first embodiment, during the coarse processing operation, the irradiation by the ion beam with the first accelerating voltage ends before the cross section of the sample S becomes parallel to the optical axis A of the ion beam. For example, if the coarse processing is terminated after the cross section of the sample S becomes parallel to the optical axis A of the ion beam, the dose of the ion beam impinging on the cross section of the sample S in the finish processing decreases. This presents the problem that it takes a long time to process the sample. In the sample preparation method associated with the first embodiment, during the coarse processing operation, the ion beam irradiation is terminated before the cross section of the sample S becomes parallel to the optical axis A of the ion beam. Consequently, the above-described problem does not occur. Accordingly, with the sample preparation method associated with the first embodiment, a cross section having a thin amorphous region can be prepared efficiently.

In the sample preparation method associated with the first embodiment, during the coarse processing operation, the irradiation by the ion beam with the first accelerating voltage ends after the angle of tilt β of the cross section of the sample S relative to the optical axis A of the ion beam has become smaller than the angle of tilt α of the side surface 41 of the shield plate 40 relative to the optical axis A of the ion beam. Therefore, with the sample preparation method associated with the first embodiment, a cross section having a thin amorphous region can be prepared efficiently.

### 2. Second Embodiment

A sample preparation apparatus associated with a second embodiment of the present invention is next described. This apparatus is similar in configuration to the above-described sample preparation apparatus 100 associated with the first embodiment and already described in connection with FIGS. 1-3. In the following, only the differences with the sample preparation apparatus 100 associated with the first embodiment are described.

FIG. 8 shows one example of control GUI screen of the sample preparation apparatus associated with the second embodiment. As shown in FIG. 8, the control GUI screen of the sample preparation apparatus associated with the second embodiment does not have the finish processing check column 924 unlike the control GUI screen of the sample preparation apparatus 100 shown in FIG. 6.

In the sample preparation apparatus associated with the second embodiment, if the processing start button 922 is depressed, a coarse processing operation is performed and then a finish processing operation is always carried out.

### 3. Example

A specific example of the present embodiment is given below to describe the present embodiment in further detail. Note that the present invention is not restricted thereby.

Silicon substrates were used as samples. The silicon substrates were processed with an Ar ion beam under different conditions, and cross sections were prepared. The thicknesses of the amorphous regions were evaluated.

Specifically, each silicon substrate was first processed with an Ar ion beam with an accelerating voltage of 8 kV. The resulting cross section of the silicon substrate was analyzed crystallographically by an electron backscatter diffraction (EBSD) method using a scanning electron microscope (SEM).

Then, the silicon substrate was processed by an Ar ion beam with an accelerating voltage of 8 kV. Then, the substrate was processed by an Ar ion beam with an accelerating voltage of 3 kV for 3 minutes. The cross section of the silicon substrate was similarly analyzed crystallographically by an EBSD method using a scanning electron microscope.

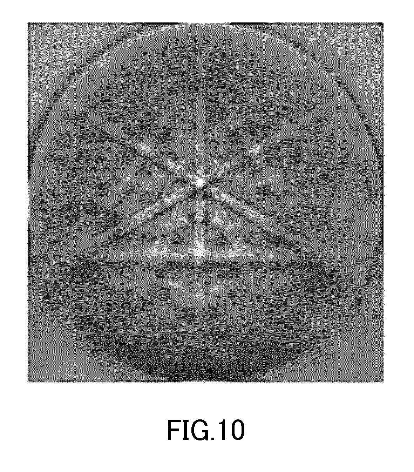

FIG. 9 shows an EBSD pattern of the cross section of the silicon substrate obtained by processing it with the Ar ion beam with an accelerating voltage of 8 kV. FIG. 10 shows an EBSD pattern of the cross section of the silicon substrate obtained by processing it with the Ar ion beam of an accelerating voltage of 8 kV and then processing the cross section with the Ar ion beam with an accelerating voltage of 3 kV for 3 minutes.

The EBSD pattern shown in FIG. 10 exhibits higher contrast and is clearer than the EBSD pattern shown in FIG. 9. With respect to IQ (image quality) used as an index of the quality of a pattern, the EBSD pattern shown in FIG. 10 has an IQ of 3275.9, while the EBSD pattern shown in FIG. 9 has an IQ of 1377.5

It has been found from the results that the cross section of the silicon substrate which was processed with the Ar ion beam with an accelerating voltage of 8 kV and then processed with the Ar ion beam with an accelerating voltage of 3 kV for 3 minutes is thinner in amorphous region than the cross section of the silicon substrate processed with the Ar ion beam with an accelerating voltage of 8 kV.

The present invention embraces configurations (e.g., configurations identical in function, method, and results or identical in purpose and advantageous effects) which are substantially identical to the configurations described in any one of the above embodiments. Furthermore, the invention embraces configurations which are similar to the configurations described in any one of the above embodiments except that their nonessential portions have been replaced. Further, the invention embraces configurations which are similar to the configurations described in any one of the above embodiments except that a well-known technique is added.

## Claims

1. A sample preparation apparatus for preparing a cross section of a sample by irradiating the sample with an ion beam, said sample preparation apparatus comprising:
an ion beam generator producing the ion beam;
a shield plate disposed to cover a part of the sample and operative to shield the sample from the ion beam; and
a controller for controlling the ion beam generator;
wherein said controller performs a first operation, wherein the controller controls the ion beam generator such that the ion beam is accelerated by a first accelerating voltage and hits the sample while the sample and the shield plate are located in a given positional relationship, and a second operation, wherein the controller controls the ion beam generator such that the ion beam is accelerated by a second accelerating voltage lower than the first accelerating voltage and hits the sample while the given positional relationship is maintained.

2. A sample preparation apparatus as set forth in claim 1, further including a storage device in which first processing conditions including information related to the first operation and about a duration of the ion beam irradiation and about the first accelerating voltage and second processing conditions including information related to the second operation and about a duration of the ion beam irradiation and about the second accelerating voltage are stored, wherein said controller performs the first operation on the basis of the first processing conditions stored in the storage device and performs the second operation on the basis of the second processing conditions stored in the storage device.

3. A sample preparation method of preparing a cross section of a sample by irradiating the sample with an ion beam, said method comprising the steps of:
performing a first operation, wherein the ion beam is accelerated by a first accelerating voltage and hits the sample while the sample and a shield plate are located in a given positional relationship; and
performing a second operation, wherein the ion beam is accelerated by a second accelerating voltage lower than the first accelerating voltage and hits the sample while said given positional relationship is maintained.

4. A sample preparation method as set forth in claim 3, wherein during said first operation, the irradiation by said ion beam with said first accelerating voltage is terminated before the cross section of the sample becomes parallel to an optical axis of the ion beam.

5. A sample preparation method as set forth in claim 3, wherein said shield plate has a side surface tilted relative to an optical axis of said ion beam, and wherein during said first operation, the irradiation by said ion beam with said first accelerating voltage is terminated after the tilt of the cross section of the sample relative to the optical axis of the ion beam becomes less steep than the tilt of the side surface of the shield plate relative to the optical axis of the ion beam.
